# FASCICULE DE BREVET EUROPEEN

(11) **EP 0 371 868 B1**
(45) Date de publication et mention de la délivrance du brevet: **11.05.1994**
(21) Numéro de dépôt: 89403277.0
(22) Date de dépôt: 27.11.1989
(51) Int. Cl.: H01L 27/16, G01J 5/34

(54) **Structure monolithique de détection ou d'imagerie infrarouge et son procédé de fabrication**
Monolithische Struktur für einen IR-Detektor oder IR-Bildsensor und Verfahren zu ihrer Herstellung
Monolithic structure for an IR detector or IR imager, and method of manufacturing the same

(30) Priorité: 29.11.1988 FR 8815581
(43) Date de publication de la demande: 06.06.1990
(73) Titulaire: COMMISSARIAT A L'ENERGIE ATOMIQUE, 75015 Paris Cédex 15 (FR)
(72) Inventeur: Audaire, Luc, F-38000 Grenoble (FR); Peuzin, Jean-Claude, F-38320 Herbeys (FR); Schaub, Bernard, F-38250 Lans-en-Vercors (FR)
(74) Mandataire: Dubois-Chabert, Guy

(56) Documents cités:
- EP-A- 0 173 368
- WO-A-88/01793
- US-A- 3 973 146
- IEEE INTERNATIONAL SYMPOSIUM ON APPLICATIONS OF FERROELECTRICS, Bethlehem, US, juin 1986, pages 172-181, BCC; R. WATTON: "Ferroelectrics for infrared detection and imaging"
- SIEMENS FORSCHUNGS- UND ENTWICKLUNGSBERICHTE, vol. 15, no. 3, 1986, pages 105-114, Springer-Verlag, Berlin, DE; H. MEIXNER et al.: "Infrared sensors based on the pyroelectric polymer polyvinylidene fluoride (PVDF)"

## Description

L'invention se rapporte à une structure monolithique ou intégrée pour la détection ou l'imagerie infrarouge ainsi que son procédé de fabrication. Elle permet la réalisation en grande série et de façon industrielle de dispositifs de prise de vue infrarouge pyroélectriques dont la complexité et le pas des senseurs élémentaires sont directement compatibles avec une visualisation sur écran au standard de télévision actuel.

A l'heure actuelle, le développement des applications civiles de l'imagerie infrarouge telles que les applications médicales, la surveillance de zones à haut risque d'incendies, est techniquement freiné par le manque d'une technologie industrielle des détecteurs à faible coût pour application grand public.

Les dispositifs de détection infrarouge sont fondés sur la propriété qu'ont un certain nombre de corps diélectriques d'avoir une polarisation spontanée, c'est-à-dire un champ électrique interne rémanent, qui varie en fonction de la température. Cette propriété est l'effet pyroélectrique.

La variation de température est proportionnelle à l'énergie du signal photonique incident. A énergie donnée, elle est d'autant plus grande que le détecteur est à faible capacité thermique ce qui conduit à réaliser une couche pyroélectrique mince pour minimiser le volume de détection.

La variation de polarisation se manifeste aux bornes du détecteur par une variation de charges. Deux électrodes métalliques déposées à la surface du diélectrique permettent de constituer un condensateur aux bornes duquel il est possible de mesurer la tension lorsqu'il est lu par un circuit à haute impédance d'entrée du type transistor MOS. Cette tension, quelques millivolts, est proportionnelle à la variation de l'énergie incidente.

Les matériaux pyroélectriques généralement utilisés sont donnés dans l'article "Pyroelectric devices and materials" de R.W. Watemoore, Rep. Prog. Phys. 49, de 1986, pp. 1335-1386.

Parmi ces matériaux, on peut citer les polymères ou copolymères du type fluorure de polyvinylidène.

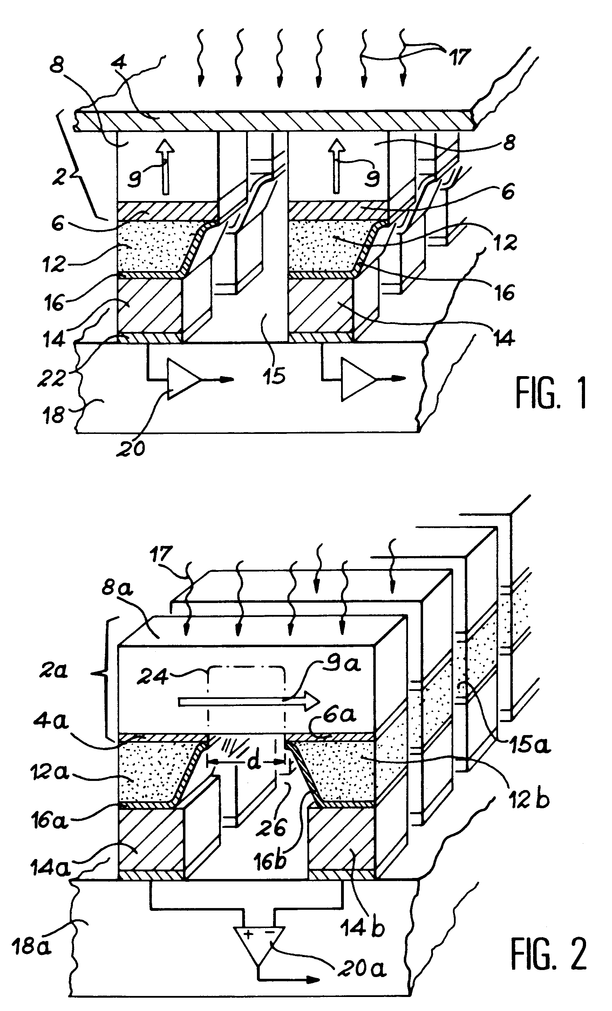

Sur la figure 1, on a représenté schématiquement, et en perspective, un premier mode de réalisation d'un détecteur à infrarouge connu, décrit en particulier dans le document "Ferroelectrics for infrared detection and imaging" de R. Watton IEEE Int. Symp. on Applications of Ferroelectrics, Juin 1986, Bethlehem, USA. Dans ce détecteur, la partie détectrice est connectée au circuit de lecture par une technique d'hybridation.

Comme représenté sur la figure 1, chaque senseur 2 du détecteur comporte deux électrodes 4 et 6 disposées sur les faces opposées du matériau pyroélectrique 8. Le vecteur de polarisation 9 doit être perpendiculaire à la surface des électrodes 4 et 6. Un matériau isolant thermique 12 isole chaque senseur 2 d'une brasure ou plot métallique 14 d'hybridation. Pour chaque senseur, une métallisation 16 assure alors le contact entre l'électrode 6 et la brasure 14.

Les senseurs 2, constituant les points élémentaires en imagerie, sont isolés thermiquement et mécaniquement les uns des autres par gravure de matériaux pyroélectrique 8, conducteur 6 et isolant 12. Cette isolation porte la référence 15.

La lecture de la tension sur l'électrode 6, résultant de l'interaction d'un rayonnement infrarouge 17 avec le détecteur, est faite, via des lignes de commande 22, dans un circuit intégré 18 réalisé dans du silicium, à l'aide d'un étage amplificateur 20 à une seule entrée, l'électrode 4 commune à tous les senseurs 2 servant de référence pour tous les senseurs. Pour simplifier la description et les figures, le circuit intégré n'est représenté que sous forme fonctionnelle.

Cette disposition du détecteur interdit un gain supérieur à 100. En outre, cette technologie nécessite un nombre important de masques et en particulier six niveaux de masquage pour la fabrication de la partie détectrice.

Une réalisation plus récente d'un dispositif de détection est représentée schématiquement, en perspective, sur la figure 2. Cette réalisation est en particulier décrite dans l'article "Type II pyroelectric detectors" de A. Hadni, Infrared Physics, vol. 27, n^{o}, pp 17-23, de 1987.

Dans cette réalisation, les deux électrodes 4a et 6a de chaque senseur 2a sont disposées sur la même face du matériau pyroélectrique 8a et sont connectées respectivement au circuit de lecture 18a par deux brasures 14a et 14b. Dans cette structure, le vecteur polarisation 9a doit être parallèle au plan des électrodes 4a et 6a. La zone utile à la détection, symbolisée en traits mixtes et référencée 24, est approximativement le volume ayant pour base la surface entre les électrodes 4a et 6a et dont la hauteur est égale à la distance d entre ces électrodes.

Cette structure est préférable à celle représentée sur la figure 1 car il n'y a pas d'électrode commune, mal soutenue dans les zones d'isolation 15 (zones entre chaque senseur) ; cette électrode commune est donc fragile et peu fiable. En outre, les deux électrodes 4a et 6a sont situées sur la face d'hybridation et permettent la lecture de chaque senseur 2a par un amplificateur différentiel 20a.

On sait que ce type d'amplificateur élimine les bruits qui apparaissent en mode commun tel que le bruit piézoélectrique et autorise ainsi, pour chaque senseur, une amplification avec un gain pouvant atteindre la valeur 1000.

Dans ce mode de réalisation, des métallisations 16a et 16b assurent respectivement le contact électrique entre les électrodes 4a, 6a et les brasures 14a et 14b. En outre, un matériau isolant thermique 12a, 12b isole chaque senseur 2a de ces deux brasures.

Là encore, l'isolation thermique et mécanique 15a des senseurs est assurée par une gravure de la couche d'isolant 12a et de la couche pyroélectrique 8a.

Les deux modes de réalisation ci-dessus présentent un certain nombre d'inconvénients.

En effet, les connexions métalliques 16, 16a, 16b entre le senseur et le circuit intégré constituent des ponts thermiques qui limitent l'élévation de températures du détecteur et donc atténuent d'autant la variation de tension, alors que le bruit de lecture n'est pas atténué ; la détection du signal infrarouge est fortement dégradée.

De plus, les contraintes topologiques liées à la réalisation des brasures ne permettent pas d'envisager une dimension de chaque senseur inférieure à 40 µm. Cette dimension est supérieure à la taille de la tache de diffraction de l'optique associée au détecteur : les senseurs limitent donc la résolution angulaire de la prise de vue.

En outre, l'opération d'hybridation n'est pas une étape technologique habituelle de la microélectronique.

Par ailleurs, les techniques utilisables pour le dépôt et la gravure des électrodes ne permettent pas de rapprocher les électrodes à une distance d (figure 2) inférieure à la dizaine de micromètres. La capacité du senseur est donc faible devant la capacité d'entrée du circuit de lecture. Il en résulte une atténuation de la tension pyroélectrique délivrée par le détecteur.

De plus, la cavité 26 sous chaque senseur 2a de la figure 2, retient des traces des produits utilisés lors du processus de fabrication. Ces produits restent actifs, lorsque le dispositif de détection est terminé, ce qui induit une dégradation de la durée de vie de ce dispositif.

Ces inconvénients sont valables quel que soit le matériau pyroélectrique utilisé. Toutefois, ces inconvénients sont beaucoup plus marqués lorsque l'on utilise comme matériau sensible, un polymère ou copolymère du type fluorure de polyvinylidène. En particulier, l'opération d'hybridation élève excessivement la température du polymère et en dégrade ses performances.

De plus, le dépôt métallique nécessaire à la réalisation des électrodes sur un film très mince de polymère induit dans ce dernier, des contraintes mécaniques qui déforment le film mince et la couche de métal. La couche métallique ainsi déformée devient impropre à la réalisation d'électrodes gravées selon les techniques de la microélectronique.

En conclusion, la technique d'hybridation des senseurs avec un circuit intégré ne permet pas la réalisation de détecteurs ou d'imageurs infrarouges, reproductibles et fiables, haute densité d'intégration.

L'intégration des circuits de lecture et des senseurs a fait l'objet d'une publication "Fully-integrated ZnO on silicon pyroelectric Infrared Detector Array" de D.L. Polla et al., Proceeding IEDM, 1984, pp. 282-284.

La technologie décrite dans cet article ne se prête pas à une intégration haute densité. En effet, le circuit de lecture et le senseur qui lui est connecté ne sont pas situés l'un au-dessus de l'autre comme décrit aux figures 1 et 2 ci-dessus. En outre, l'amincissement du silicium nécessaire à la détection ne peut pas être fait à un faible pas, inférieur à 10 micromètres.

L'invention a justement pour objet une structure monolithique de détection ou d'imagerie infrarouge ainsi que son procédé de fabrication, permettant de remédier aux différents inconvénients donnés ci-dessus. En particulier, elle permet la réalisation en grande série, avec un faible cout de fabrication, de dispositifs de prise de vue infrarouge de complexité comparable à celles des dispositifs de détection utilisés en imagerie visible et de pas de points élémentaires de détection de l'ordre de 10 micromètres.

De façon plus précise, l'invention a pour objet une structure monolithique de détection ou d'imagerie infrarouge comprenant :
- au moins une couche de polymère isolant électrique et thermique ayant une face supérieure et une face inférieure,
- des senseurs à infrarouge, reposant sur la face supérieure de la couche d'isolant et isolés les uns des autres, comportant un film pyroélectrique de polymère dont la face au contact de la couche d'isolant est équipée de deux électrodes en forme de peigne dont les dents sont imbriquées, le film pyroélectrique de polymère étant polarisé dans un plan parallèle à ladite face du film selon des directions parallèle et perpendiculaire aux dents des peignes,
- un circuit intégré comportant une face au contact de la face inférieure de la couche isolant équipée de circuits de lecture,
- des zones de contact électrique traversant de part en part la couche d'isolant et connectant les électrodes de chaque senseur à un circuit de lecture.

Par senseurs isolés, il faut comprendre des senseurs isolés thermiquement, mécaniquement et électriquement.

La structure monolithique de l'invention permet d'exploiter au maximum les propriétés pyroélectriques des polymères pour la réalisation industrielle de détecteurs solides infrarouges fiables dont la complexité est comparable à celle des CCD utilisés en prise de vue dans le visible ; la résolution angulaire est alors limitée par celle imposée par l'optique associée à la structure et non l'inverse comme dans l'art antérieur.

Le polymère isolant électrique et thermique doit avoir une conductivité thermique <0,4 W/(mK) et une résistivité >10¹⁶Ω.cm.

Comme polymère isolant électrique et thermique utilisables dans l'invention, on peut citer les polyuréthanes, les polyesters, les polyimides. De préférence, on utilise une couche de polyimide. Ce matériau est utilisé non seulement grâce à ses propriétés connues en microlithographie mais encore grâce à ses propriétés d'isolant thermique qui ne sont jamais utilisées.

Comme matériau pyroélectrique, on peut utiliser tout type de polymère pyroélectrique comme par exemple les polymères polyvinyliques tels que le fluorure de polyvinylidène connu sous l'abréviation PVDF.

De préférence, on utilise des copolymères de fluorure de vinylidène et de trifluoroéthylène connus sous l'abréviation VDF-TRFE.

Ces copolymères outre leur faible coût présentent deux intérêts majeurs :
a) ils sont disponibles avant polymérisation en solution visqueuse. Ils peuvent donc être déposés sur un circuit intégré selon la technique habituellement utilisée pour le dépôt des résines de masquage en technologie micronique. Les couches peuvent avoir une épaisseur aussi faible que 100 nm. Or, à l'encontre des autres corps pyroélectriques, la réalisation de couches minces n'impliquent aucun processus de cristallogénèse toujours complexe et onéreux.
b) la polarisation spontanée y est formée après ou pendant la polymérisation en imposant dans le volume du détecteur un champ électrique supérieur à un champ critique. Dans les autres composés la polarisation spontanée dépend de l'orientation cristalline. Cette nécessité d'orientation rend encore plus complexe une cristallogénèse des couches minces.

L'invention a aussi pour objet un procédé de fabrication de la structure monolithique décrite précédemment. Ce procédé comprend les étapes suivantes :
a) dépôt d'au moins une couche de polymère isolant électrique et thermique à la surface d'un circuit intégré équipée de circuits de lecture puis polymérisation de cette couche,
b) réalisation de zones de contact électrique en regard des circuits de lecture, traversant de part en part la couche d'isolant,
c) dépôt d'une couche conductrice à la surface de la couche d'isolant et des zones de contact,
d) réalisation de paires d'électrodes dans la couche conductrice, ayant la forme de peignes, ces électrodes étant situées en regard des zones de contact électrique, les dents des électrodes de chaque paire étant imbriquées,
e) dépôt d'un film pyroélectrique de polymère sur la structure obtenue en d) puis polymérisation de ce film,
f) réalisation d'un plot pyroélectrique dans le film pyroélectrique en regard de chaque paire d'électrodes, et
g) polarisation des plots pyroélectriques dans un plan parallèle à la surface de la couche d'isolant et selon des directions parallèle et perpendiculaire aux dents des peignes, chaque plot polarisé et la paire d'électrodes en contact avec lui constituant un senseur à infrarouge.

Le procédé de fabrication de la structure de l'invention a l'avantage de ne mettre en oeuvre que des étapes technologiques utilisées habituellement dans la réalisation des circuits intégrés microniques ou submicroniques du type HCMOS. Cette technologie permet d'optimiser les performances thermiques du senseur élémentaire et d'adapter son impédance à celui du circuit de lecture ; de ce fait, elle en tire un meilleur parti.

En outre, le pas du détecteur ou de l'imageur infrarouge ainsi que sa complexité ne sont plus imposés par la technique d'hybridation. La technique de microlithogravure mise en oeuvre dans l'invention autorise la réalisation de vidicons solides infrarouges dont le pas du point élémentaire est de l'ordre de la dizaine de micromètres dans des matrices de senseurs comportant en particulier 400 lignes de 600 points, compatibles avec la visualisation directe de l'image sur un moniteur standard au format télévision.

Par ailleurs, la technologie des senseurs étant indépendante de la technologie du circuit de lecture, elle n'implique donc aucune élévation de température. Aussi, les senseurs peuvent être réalisés sur n'importe quel circuit de lecture connu, et en particulier sur des circuits en technologie AsGa ou silicium, les mieux adaptés.

L'orientation de la polarisation rémanente résultante étant réalisée en fin de processus technologique, elle peut être répétée chaque fois qu'un événement accidentel, par exemple une température de stockage excessive, a dégradé cette polarisation.

La structure de l'invention est monolithique ce qui élimine naturellement l'inconvénient lié au résidu de produits utilisés lors du processus technologique et conduit à une fiabilité qui est celle de la microélectronique. La durée de vie des détecteurs et imageurs utilisant la structure de l'invention peut être évaluée à 5 fois celle des dispositifs de l'art antérieur.

De façon avantageuse, la polarisation rémanente du film pyroélectrique est obtenue en utilisant les électrodes des senseurs ce qui assure l'orientation optimale du champ rémanent dans chaque senseur et ce, quelle que soit la géométrie des électrodes.

Les zones de contact électrique peuvent être réalisées par gravure de la couche d'isolant puis dépôt d'une couche métallique selon les technologies connues en microélectronique. Elles peuvent aussi être obtenues soit par implantation d'ions, au travers d'un masque, rendant localement conducteur la couche d'isolant, soit préférentiellement par une modification locale des propriétés électriques du polymère selon une technique propre à la chimie organique, comme décrit dans l'article "Method for increasing the conductivity of silver-doped polyimides" de A. Auerbach, J. Electrochem. Soc., d'avril 1984, p. 937-938.

Ces techniques permettent de réaliser des contacts aussi petits que 2 micromètres de côté et permettent en conséquence d'atteindre une taille de détecteur ou d'imageur infrarouge complet qui n'est pas réalisable par les procédés classiques d'hybridation.

De façon avantageuse, les électrodes sont réalisées en déposant une couche conductrice en métal sur l'ensemble de la structure, en masquant les régions de cette couche de métal que l'on désire garder à l'aide d'une résine photosensible puis en gravant de façon anisotrope la couche de métal. Cette technique microélectronique permet de rapprocher les électrodes de chaque senseur le plus près possible, à moins de 1 µm, et donc de maximiser la capacité électrique totale du détecteur ou de l'imageur tout en conservant un volume de détection suffisant.

Le dépôt du film pyroélectrique intervenant en fin de processus technologique évite que ce dernier subisse une élévation de température risquant de dégrader ses propriétés pyroélectriques.

La réalisation des senseurs infrarouges par le procédé conforme à l'invention est beaucoup plus simple que celle de l'art antérieur. En effet, elle ne nécessite que 3 niveaux de masquage au lieu de 6 et les étapes ne sont nullement critiques.

D'autres caractéristiques et avantages de l'invention ressortiront mieux de la description qui va suivre donnée à titre illustratif et non limitatif en référence aux figures 3 à 6 annexées, les figures 1 et 2 ayant déjà été décrites.
- la figure 3 représente schématiquement, en vue de dessus, une structure monolithique de détection selon l'invention,
- la figure 4 est une vue en perspective de la structure de la figure 3,
- la figure 5 illustre les différentes étapes de fabrication de la structure monolithique de l'invention, dans un plan passant par la ligne A-A de la figure 3 pour les parties A-C, E et F et en perspective pour la partie D, et
- la figure 6 illustre schématiquement, en coupe un dispositif utilisant la structure de l'invention, capable d'effectuer, en analogie dans le plan focal de l'optique associée au détecteur, certains traitements d'image.

La description ci-après se rapporte à un détecteur à infrarouge en vue d'une simplification. Pour un imageur, il suffit de compléter la structure décrite par une optique appropriée, placée entre la partie détectrice et le rayonnement et de compléter les circuits de lecture par des circuits de traitement. Ces modifications sont évidentes pour l'homme de l'art spécialiste en imagerie infrarouge.

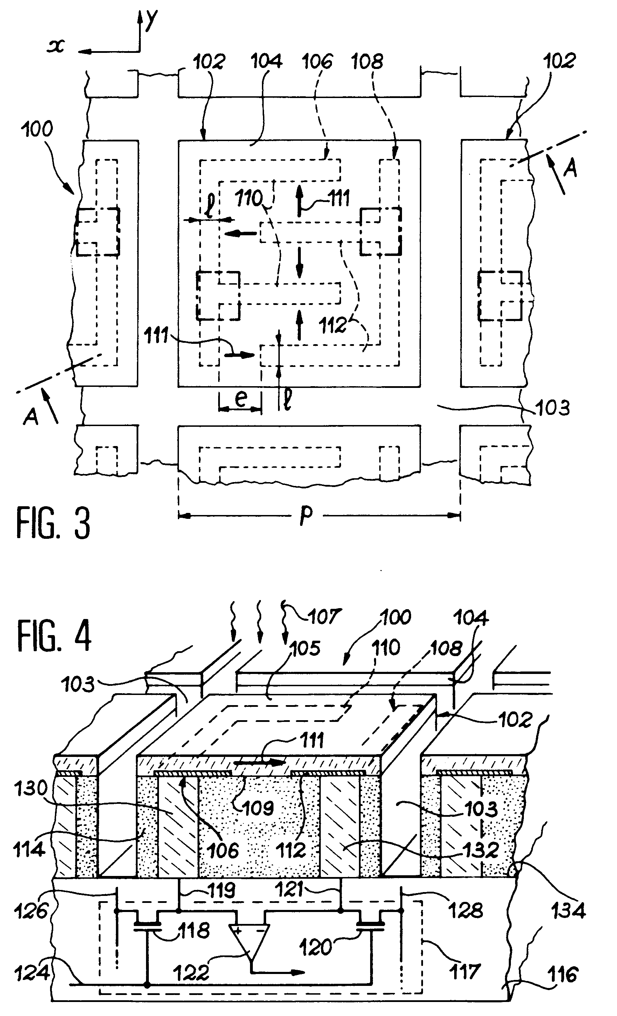

En référence aux figures 3 et 4, la structure monolithique de l'invention comprend une matrice 100 de senseurs à infrarouge 102 à un pas p, isolés électriquement, thermiquement et mécaniquement les uns des autres par des tranchées 103. Ces senseurs 102 font 10 micromètres de côté et le pas p vaut environ 12 micromètres.

Ces senseurs comportent chacun un film 104 de fluorure de polyvinylidène -CH₂-CF₂-de 1 micromètre d'épaisseur, dont la face supérieure 105 est destinée à recevoir le rayonnement infrarouge 107 à détecter ou utiliser pour l'imagerie.

La face inférieure 109 du film 104, pour chaque senseur 102, est équipée de deux électrodes 106 et 108 ayant chacune la forme de peignes dont les dents sont imbriquées ; les dents 110 de l'électrode 106 pénètrent entre les dents 112 de l'électrode 108. Les électrodes 108 et 106 sont en particulier réalisées en un polymère conducteur tel que les polyanilines ou en un métal habituellement utilisé en microélectronique tel que le chrome. Elles présentent une épaisseur de 100 nm. Les distances e séparant les dents 110 et 112 sont de 2 micromètres et la largeur 1 des électrodes est de 1 micromètre.

Selon l'invention, le vecteur de polarisation 111 est parallèle aux faces 105 et 109 du film et orienté selon la direction x parallèle aux dents 110 et 112 et selon la direction y perpendiculaire à ces dents.

Les senseurs 102 reposent chacun sur un bloc 114 de polymère isolant thermique et électrique et en particulier de polyimide PIQ de chez Dupont de Nemours, de 5 micromètres d'épaisseur.

Les blocs 114 d'isolant reposent sur un circuit intégré 116 réalisé en technologie silicium, comportant des circuits de lecture 117. Chaque circuit de lecture 117 est associé à un seul senseur 102. Il comporte deux transistors MOS 118 et 120 fonctionnant en interrupteur, reliés à un amplificateur différentiel 122.

Les transistors 118 et 120 sont commandés par une ligne de commande 124 permettant de connecter les lignes conductrices 126 et 128 respectivement à toutes les électrodes 106 et 108 des points élémentaires de la matrice de senseurs, via des zones de contact électrique respectivement 130 et 132 ; les zones de contact électrique associées à chaque senseur traversent de part en part le bloc de polyimide 114 correspondant.

Les liaisons électriques entre les transistors 118 et 120 et respectivement les zones de contact 130 et 132 sont assurées par des connexions 119 et 121 du circuit intégré.

Les surfaces de contact 130 et 132 sont de 2 micromètres x 2 micromètres.

Le circuit de lecture a été représenté sous forme symbolique et non sous forme de couches technologiques en vue d'une simplification. La réalisation technologique de ce circuit est bien connue de l'homme de l'art.

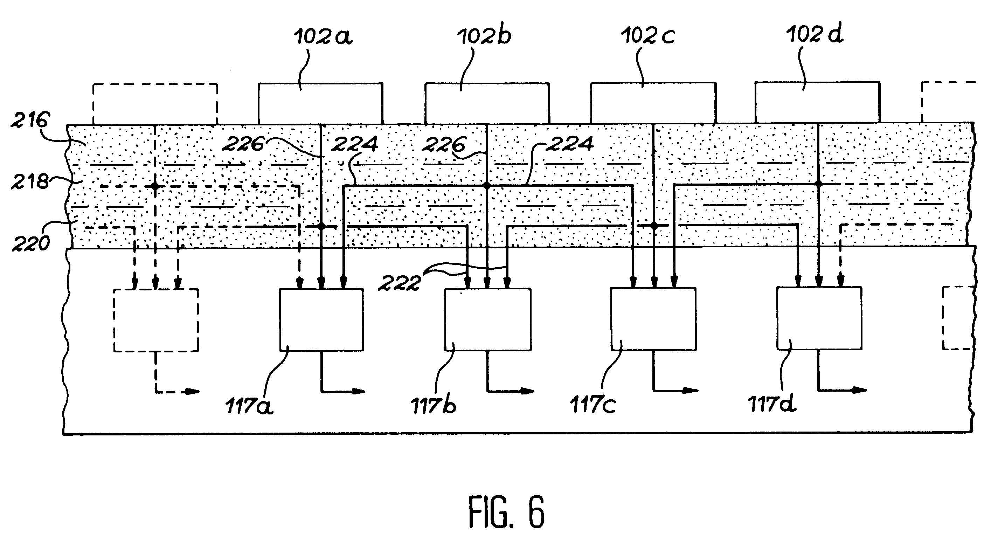

Les tranchées 103 d'isolation mécanique, électrique et thermique des senseurs 102 s'étendent jusqu'à la surface 134 supérieure du circuit intégré 116, bien qu'une isolation sur uniquement l'épaisseur du matériau pyroélectrique 104 soit suffisante (voir figure 6).

Relativement à la technologie habituelle, la densité de points élémentaires dans une structure de l'invention est multipliée par 16. La prise de vue est alors limitée par la tache de diffraction de l'optique.

Le fonctionnement de la structure conforme à l'invention est identique à celui décrit dans l'art antérieur.

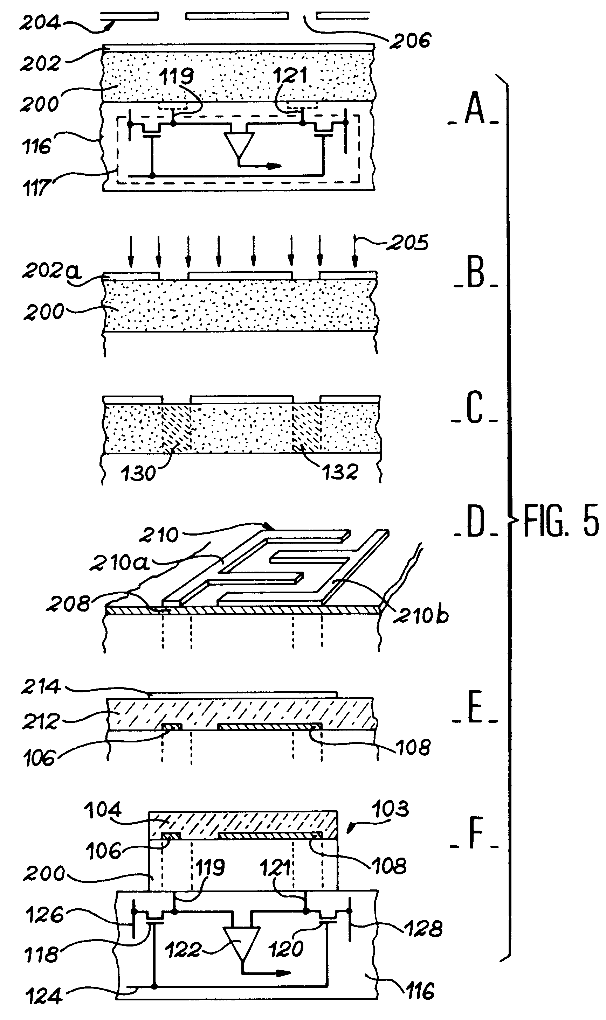

En référence à la figure 5, on décrit ci-après un premier mode de mise en oeuvre du procédé de fabrication de la structure conforme à l'invention.

Après avoir intégré les circuits de lecture 117 sur un substrat en silicium par les procédés classiques de photolithogravure, on dépose, sur l'ensemble du circuit intégré 116, une couche de polyimide 200, polymère couramment utilisé en photolitographie. Cette couche 200 est déposée selon la technique de couchage des résines habituellement utilisées comme photomasque. L'épaisseur de cette couche est contrôlée selon la technique habituelle de façon à optimiser sa conductance thermique de fuite. Elle présente une épaisseur pouvant aller de 0,1 à 10 micromètres et valant en particulier 1 micromètre. La structure obtenue est celle représentée sur la partie A de la figure 5. On effectue ensuite un traitement thermique à la température prescrite par le fournisseur pour polymériser le polyimide.

Sur l'ensemble de la structure on dépose alors une couche 202 de résine photosensible telle que celles classiquement utilisées en microélectronique par la technique de couchage. Cette résine est en particulier une résine S 1400-27 de chez SHIPLEY. Elle présente une épaisseur de 1 µm.

On effectue alors une insolation de la couche de résine 202, à travers un masque mécanique 204, pour définir l'emplacement des zones de contact électrique 130 et 132 à réaliser. Le masque mécanique utilisé doit être tel que ses ouvertures 206 soient situées en regard des connexions 119 et 121 des transistors 118 et 120 du circuit de lecture.

Après développement dans un développeur de chez SHIPLEY, on obtient la structure représentée sur la partie B. Les zones insolées de la couche de résine 202 ont été éliminées.

A l'aide de ce premier masque de résine 202a ainsi formé, on réalise ensuite les zones de contact électrique 130 et 132.

A travers ce masque de résine 202a, on effectue alors une implantation d'ions 205 dans la couche de polyimide 200 rendant localement le polyimide conducteur (zones 130 et 132). Cette implantation est réalisée par exemple avec des ions d'arsenic à une énergie de 200 KeV et une dose de 10²⁰ions/cm³.

Cette étape technologique qui a formé 1 µm d'isolant thermique ainsi que les zones 130 et 132 est répétée 5 fois de façon à obtenir une épaisseur d'isolant thermique de 5 µm.

La structure obtenue, après implantation, est celle représentée sur la partie C de la figure 5.

Après élimination du dernier masque de résine à l'aide d'un plasma d'oxygène, on effectue alors, comme représenté sur la partie D de la figure 5, le dépôt d'une couche conductrice 208, cette couche 208 est en particulier une couche de chrome déposée par pulvérisation magnétron de 100 nm d'épaisseur.

On forme alors comme décrit précédemment, en référence à la partie A, un second masque de résine 210 définissant l'emplacement des électrodes 106 et 108 à réaliser dans la couche 208. A cet effet, le masque 210 assure le masquage des régions de la couche conductrice que l'on désire garder et expose celles que l'on désire éliminer.

Le masque 210 se présente sous la forme d'une multitude de peignes 210a, 210b associés deux à deux, dont les dents sont imbriquées, pour obtenir les électrodes 106 et 108 telles que représentées sur la figure 3.

On effectue alors une gravure anisotrope de la couche 208 à l'aide du masque 210. Pour une couche de chrome, on utilise un plasma chloré comme agent d'attaque. La structure obtenue est représentée sur la partie E de la figure 5.

Après élimination du masque 210, à l'aide d'un plasma d'oxygène, on effectue le dépôt d'une couche 212 de fluorure de polyvinylidène selon la technique de couchage des résines habituellement utilisées en microélectronique. Son épaisseur est aisément contrôlée afin d'optimiser la capacité thermique des senseurs et de l'adapter à la conductance de fuite thermique du polyimide. En particulier, la couche 212 a une épaisseur allant de 0,1 à 10 micromètres et valant en particulier 1 micromètre. Un recuit de 8h à 80°C permet une polymérisation du film 212 de polyvinyle ; cette polymérisation du film pyroélectrique 212 permet de le faire adhérer au polyimide 200 qui en évite ainsi les déformations.

On effectue alors par les procédés classiques de photolithographie (voir partie A de la figure 5) un troisième masque 214 définissant les dimensions et l'emplacement des senseurs 102 ainsi que leur isolation 103. Ce masque doit en particulier recouvrir les électrodes 106 et 108 de chaque senseur 102.

A l'aide de ce masque 214, on effectue alors une gravure anisotrope du film pyroélectrique 212 en utilisant un plasma d'oxygène. Ce plasma d'oxygène, en plus de la gravure du film de polyvinyle 212, assure l'élimination du masque de résine 214 ainsi que la gravure du polyimide 200. La structure obtenue est celle représentée sur la partie F de la figure 5.

La dernière étape du procédé consiste à polariser les plots pyroélectriques 104 obtenus en imposant une tension entre les électrodes 108 et 106 de chaque senseur 102. Le circuit destiné à cette polarisation constitue en particulier une partie du circuit intégré 116. Ceci permet la repolarisation des plots pyroélectriques 104 en cas de besoin.

Conformément à l'invention, la tension nécessaire pour former la polarisation spontanée 111 (voir figure 3) est appliquée collectivement aux senseurs 102 en connectant les électrodes 106 de tous les senseurs à la ligne de commande 126, via les interrupteurs MOS 118 et les connexions 119 et les électrodes 108 à la ligne de commande 128 via les interrupteurs MOS 120 et les connexions 121, pendant un temps qui est déterminé par le signal appliqué à la ligne 124 et donc sur les grilles des transistors. Ce signal est en particulier une tension continue de 50 volts et est appliqué pendant 60 min.

L'orientation de la polarisation rémanente résultante, imposée par la forme des électrodes 106 et 108, est spontanément optimale pour la lecture de la tension pyroélectrique du fait de l'utilisation de ces électrodes pour la polarisation des blocs pyroélectriques.

Selon un second mode de mise en oeuvre du procédé de l'invention, on forme les zones de contact électrique 130 comme décrit dans l'article de A. Auerbach cité précédemment. A cet effet, la couche de polymère à déposer (partie A) sur le circuit intégré 116 est constituée d'un mélange d'acide polyamique et d'un sel métallique tel que le nitrate d'argent dissous dans un solvant organique ; la composition du mélange est celui de l'art antérieur. Cette couche est déposée par la technique classique de couchage des résines de la microélectronique. Un séchage de la couche déposée permet l'élimination du solvant organique et sa polymérisation.

La réalisation des zones de contact électrique 130 et 132 consiste alors à soumettre le polyimide déposé à des particules de carbone accéléré, en utilisant le masque de résine 205 (partie B), pour réduire localement les ions argent en métal et imidiser l'acide polyamique. Cette étape de réduction des ions argent est effectuée à 360°C.

La structure matricielle de prise de vue décrite en référence aux figures 3 et 4 est la plus simple envisageable. En effet, chaque senseur 102 est connecté à un circuit de lecture 117 et un seul.

Toutefois, le procédé de l'invention se prête à des structures de senseurs beaucoup plus complexes dont le fonctionnement s'apparente à celui de la rétine de l'oeil.

La figure 6 schématise en coupe la structure d'un détecteur capable d'effectuer, en analogique, dans le plan focal d'une optique appropriée, certains traitements d'images. Ce détecteur comporte plusieurs senseurs 102a, 102b, 102c et 102d connectés chacun à trois circuits de lecture. Le senseur 102b est connecté au circuit de lecture 117a, 117b et 117c, le senseur 102c est connecté au circuit de lecture 117b, 117c, 117d, etc ... au moyen de zones de contact similaires aux zones 130 et 132 de la figure 4.

Dans la structure de la figure 6, les senseurs 102a, 102b, 102c et 102d reposent sur un empilement de trois couches de polyimide 216, 218 et 220. Ces couches sont déposées successivement sur le circuit intégré 116 puis polymérisées.

Après la polymérisation de la couche de polyimide 220, on effectue les zones de contact 222 traversant de part en part la couche de polyimide 220. De même, après la polymérisation de la couche de polyimide 218 on réalise les zones de contact 224, traversant de part en part la couche 218 et la couche 220 et enfin, après la polymérisation de la couche 216, on effectue les zones de contact 226 traversant de part en part les trois couches de polyimide.

Par ce procédé d'assemblage, qui découle de celui décrit précédemment, on conserve l'isolement thermique lié à l'utilisation du polyimide tout en réalisant des connexions multiples liées au traitement d'images.

Cette invention trouve des applications en particulier dans le domaine de l'automobile. Plus précisément, elle est adaptée à la détection d'obstacles sur la route pour éviter par exemple des collisions multiples dans des conditions de faible visibilité.

## Revendications

1. Structure monolithique de détection ou d'imagerie infrarouge comprenant :
- au moins une couche de polymère (114, 216, 218, 220) isolant électrique et thermique ayant une face supérieure et une face inférieure,
- des senseurs (102, 102a, 102b, 102c, 102d) à infrarouge, reposant sur la face supérieure de la couche d'isolant et isolés les uns des autres (103), comportant un film pyroélectrique (104) de polymère dont la face (109) au contact de la couche d'isolant (114) est équipée de deux électrodes (106, 108) en forme de peigne dont les dents (110, 112) sont imbriquées, le film pyroélectrique (104) de polymère étant polarisé (111) dans un plan parallèle à ladite face du film selon des directions parallèle (x) et perpendiculaire (y) aux dents des peignes,
- un circuit intégré (116) comportant une face (134) au contact de la face inférieure de la couche d'isolant (114) équipée de circuits de lecture (117, 117a, 117b, 117c, 117d),
- des zones de contact électrique (130, 132, 222, 224, 226) traversant de part en part la couche d'isolant et connectant les électrodes (106, 108) de chaque senseur à au moins un circuit de lecture (117, 117a, 117b, 117c, 117d).

2. Structure monolithique selon la revendication 1, caractérisée en ce que la couche d'isolant (114, 216, 218, 220) est une couche de polyimide.

3. Structure monolithique selon la revendication 1 ou 2, caractérisée en ce que le film de polymère (104) est un polymère ou un copolymère de fluorure de polyvinylidène.

4. Structure monolithique selon l'une quelconque des revendications 1 à 3, caractérisée en ce que chaque circuit de lecture comprend deux transistors MOS (118, 120) fonctionnant en interrupteur, connectés à un amplificateur différentiel (122).

5. Structure monolithique selon l'une quelconque des revendications 1 à 4, caractérisée en ce qu'elle comprend trois couches empilées d'isolant électrique et thermique (216, 218, 220), n senseurs (102a-102d), un circuit intégré (116) comportant n+2 circuits de lecture (117a-117d), et des zones de contact électrique (222, 224, 226), traversant de part en part au moins une couche d'isolant et agencées de sorte que le senseur i, avec 1≦i≦n, soit connecté aux trois circuits de lecture i, i+1 et i+2.

6. Procédé de fabrication d'une structure monolithique de détection ou d'imagerie infrarouge comprenant les étapes suivantes :
a) dépôt d'au moins une couche de polymère (200, 216, 218, 220) isolant électrique et thermique à la surface d'un circuit intégré (116) équipée de circuits de lecture (117, 117a-117d) puis polymérisation de cette couche,
b) réalisation de zones de contact électrique (130, 132, 222, 224, 226) en regard des circuits de lecture, traversant de part en part la couche d'isolant,
c) dépôt d'une couche conductrice (208) à la surface de la couche d'isolant et des zones de contact,
d) réalisation de paires d'électrodes (106, 108) dans la couche conductrice (208), ayant la forme de peignes, ces électrodes étant situées en regard des zones de contact électrique, les dents (110, 112) des électrodes de chaque paire étant imbriquées,
e) dépôt d'un film pyroélectrique (212) de polymère sur la structure obtenue en d) puis polymérisation de ce film,
f) réalisation d'un plot pyroélectrique (104) dans le film pyroélectrique en regard de chaque paire d'électrodes, et
g) polarisation (111) des plots pyroélectriques dans un plan parallèle à la surface de la couche d'isolant et selon des directions parallèle (x) et perpendiculaire (y) aux dents (110, 112) des peignes, chaque plot polarisé et la paire d'électrodes en contact avec lui constituant un senseur (102, 102a-102d) à infrarouge.

7. Procédé selon la revendication 6, caractérisé en ce que la couche d'isolant est une couche de polyimide.

8. Procédé selon la revendication 7, caractérisé en ce que l'on forme les zones de contact dans la couche d'isolant (200, 220, 222, 224) par modification chimique locale de ladite couche.

9. Procédé selon l'une quelconque des revendications 6 à 8, caractérisé en ce que le film pyroélectrique (214) est en fluorure de polyvinylidène.

10. Procédé selon l'une quelconque des revendications 6 à 9, caractérisé en ce que l'on polarise les plots pyroélectriques simultanément, en utilisant les électrodes (106, 108) de chaque senseur pour véhiculer le signal de polarisation.

11. Procédé selon l'une quelconque des revendications 6 à 10, caractérisé en ce que les électrodes (106, 108) sont formées par gravure anisotrope de la couche conductrice (208) en utilisant un masque (210) de gravure de forme appropriée.

12. Procédé selon l'une quelconque des revendications 6 à 11, caractérisé en ce que les plots pyroélectriques (104) sont formés par gravure anisotrope du film pyroélectrique (212) en utilisant un masque (214) de gravure de forme appropriée.

## Claims

1. Monolithic detection or infrared imaging structure comprising at least one electrically and thermally insulating polymer layer (114, 216, 218, 220), having an upper face and a lower face, infrared sensors (102, 102a, 102b, 102c, 102d), resting on the upper face of the insulating layer, which are insulated from one another and have a pyroelectric polymer film (104), whose face (109) in contact with the insulating layer (114) is equipped with two comb-shaped electrodes (106, 108), whose teeth (110, 112) are imbricated, the pyroelectric polymer film (104) heing polarized (111) in a plane parallel to said face of the film in directions parallel (x) and perpendicular (y) to the teeth of the combs, an integrated circuit (116) having a face (134) in contact with the lower face of the insulating layer (114) equipped with reading circuits (117, 117a, 117b, 117c, 117d) and electrical contact zones (130, 132, 222, 224, 226) completely traversing the insulating layer and connecting the electrodes (106, 108) of each sensor to a reading circuit (117, 117a, 117b, 117c, 117d).

2. Monolithic structure according to claim 1, characterized in that the insulating layer (114, 216, 218, 220) is a polyimide layer.

3. Monolithic structure according to claim 1 or 2, characterized in that the polymer film (104) is a polymer or copolymer of polyvinylidene fluoride.

4. Monolithic structure according to any one of the claims 1 to 3, characterized in that each reading circuit comprises two MOS transistors (118, 120) operating as a switch and connected to a differential amplifier (122).

5. Monolithic structure according to any one of the claims 1 to 4, characterized in that it comprises three stacked electrical and thermal insulating layers (216, 218, 220), n sensors (102a-102d), an integrated circuit (116) having n+2 reading circuits (117a-117d) and electric contact zones (222, 224, 226) at least traversing an insulating layer and arranged in such a way that the sensors i, with 1 ≦ i ≦ n, is connected to the three reading circuits i, i+1 and +2.

6. Process for the production of a monolithic detection or infrared imaging structure comprising the following stages:
a) depositing at least one electrically and thermally insulating polymer layer (200, 216, 218, 220) on the surface of an integrated circuit (116) equipped with reading circuits (117, 117a-117d), followed by polymerization of the said layer,
b) producing electric contact zones (130, 132, 22, 224, 226) facing the reading circuits and passing through the insulating layer,
c) deposition of a conductive layer (208) on the surface of the insulating layer and contact zones,
d) production of electrode pairs (106, 108) in the conductive layer (208) and which are shaped like combs, said electrodes facing the electric contact zones, the teeth (110, 112) of the electrodes of each pair being imbricated,
e) deposition of a pyroelectric polymer film (212) on the structure obtained in d), followed by the polymerization of said film,
f) production of a pyroelectric contact element (104) in the pyroelectric film facing each electrode pair and
g) polarization (111) of the contact elements in a plane parallel to the surface of the insulating layer and in directions parallel (x) and perpendicular (y) to the teeth (110, 112) of the combs, each polarized contact element and the pair of electrodes in contact with it constituting an infrared sensor (102, 102a-102d).

7. Process according to claim 6, characterized in that the insulating layer is a polyimide layer.

8. Process according to claim 7, characterized in that the contact zones are formed in the insulating layer (200, 220, 222, 224) by local chemical modification of said layer.

9. Process according to any one of the claims 6 to 8, characterized in that the pyroelectric film (214) is of polyvinylidene fluoride.

10. Process according to any one of the claims 1 to 9, characterized in that the pyroelectric contact elements are simultaneously polarized by using the electrodes (106, 108) of each sensor to carry the polarization signal.

11. Process according to any one of the claims 6 to 10, characterized in that the electrodes (106, 108) are formed by anisotropic etching of the conductive layer (208) using an appropriately shaped etching mask (210).

12. Process according to any one of the claims 6 to 11, characterized in that the pyroelectric elements (104) are formed by anisotropic etching of the pyroelectric film (212) using an appropriately shaped etching mask (214).

## Patentansprüche

1. Monolithische Struktur für einen IR-Detektor oder IR-Bildsensor, umfassend:
- wenigstens eine, einen elektrischen und thermischen Isolator bildende Polymerschicht (114, 216, 218, 220) mit einer Oberseite und einer Unterseite,
- Infrarot-Sensoren (102, 102a, 102b, 102c, 102d), auf der Oberseite der Isolatorschicht ruhend und voneinander beabstandet (103), die einen pyroelektrischen Film (104) aus Polymer enthalten, dessen Seite 109, die Kontakt hat mit der Isolatorschicht (114), versehen ist mit kammförmigen Elektroden (106, 108), deren Zähne (110, 112) verschachtelt sind, wobei der pyroelektrische Polymerfilm (104) polarisiert ist (111) in einer Ebene, die parallel ist zu der genannten Seite des Films in Richtungen, die parallel (x) und senkrecht (y) sind zu den Zähnen der Kämme,
- eine integrierte Schaltung (116), die eine Seite (134) aufweist, in Kontakt mit der Oberseite der Isolatorschicht (114), die versehen ist Leseschaltungen (117, 117a, 117b, 117c, 117d),
- elektrische Kontaktzonen (130, 132, 222, 224, 226), die die Isolatorschicht durchqueren und die Elektroden (106, 108) von jedem Sensor mit wenigstens einer Leseschaltung (117, 117a, 117b, 117c, 117d) verbinden.

2. Monolithische Struktur nach Anspruch 1, dadurch gekennzeichnet, daß die Isolatorschicht (114, 216, 218, 220) eine Polyimidschicht ist.

3. Monolithische Struktur nach Anspruch 1 oder 2, dadurch gekennzeichnet, daß der Polymerfilm (104) ein Polyvinylidenfluorid-Polymer oder -Copolymer ist.

4. Monolithische Struktur nach einem der Ansprüche 1 bis 3, dadurch gekennzeichnet, daß jede Leseschaltung zwei MOS-Transistoren (118, 120) enthält, die als Schalter wirken und mit einem Differentialverstärker (122) verbunden sind.

5. Monolithische Struktur nach einem der Ansprüche 1 bis 4, dadurch gekennzeichnet, daß sie drei gestapelte elektrische und thermische Isolationsschichten (216, 218, 220) umfaßt, n Sensoren (102a-102d), eine integrierte Schaltung (116), n+2 Leseschaltungen (117a-117d) enthaltend, und elektrische Kontaktzonen (222, 224, 226), die wenigstens eine Isolationsschicht von einer Seite zur anderen durchdringen und so angeordnet sind, daß der Sensor i, mit 1<i<n, verbunden ist mit den drei Leseschaltungen i, i+1 und i+2.

6. Herstellungsverfahren einer monolithischen Struktur für einen Infrarot-Detetektor oder -Bildsensor, das die folgenden Schritte umfaßt:
a) Abscheiden von wenigsten einer elektrisch und thermisch isolierenden Polymerschicht (200, 216, 218, 220) auf der Oberfläche einer mit Leseschaltungen (117, 117a-117d) versehenen integrierten Schaltung (116), dann Polymerisation dieser Schicht,
b) Herstellen von elektrischen Kontaktzonen (130, 132, 222, 224, 226) gegenüber diesen Leseschaltungen, die die isolierende Schicht von einer Seite zur anderen durchdringen,
c) Abscheiden einer leitenden Schicht (208) auf der Oberfläche der isolierenden Schicht und den Kontaktzonen,
d) Herstellen von Elektrodenpaaren (106, 108) in der leitenden Schicht (208), die die Form von Kämmen aufweisen, wobei diese Elektroden sich gegenüber der elektrischen Kontaktzonen befinden und die Zähne (110, 112) der Elektroden jedes Paars verschachtelt sind,
e) Abscheiden eines pyroelektrischen Films (212) aus Polymer auf der in d) erhaltenen Struktur, dann Polymerisation dieses Films,
f) Herstellen eines pyroelektrischen Elements (104) in dem pyroelektrischen Film gegenüber eines jeden Elektrodenpaars, und
g) Polarisierung (111) der pyroelektrischen Elemente in einer Ebene, die parallel ist zur Oberfläche der isolierenden Schicht und in Richtungen, die parallel (x) und senkrecht (y) verlaufen zu den Zähnen (110, 112) der Kämme, wobei jedes polarisierte Element und das mit ihm Kontakt habende Elektrodenpaar einen Infrarot-Sensor (102, 102a-102d) bilden.

7. Verfahren nach Anspruch 6, dadurch gekennzeichnet, daß die isolierende Schicht eine Polyimidschicht ist.

8. Verfahren nach Anspruch 7, dadurch gekennzeichnet, daß man die Kontaktzonen in der isolierenden Schicht (200, 220, 222, 224) durch lokale chemische Veränderung der genannten Schicht bildet.

9. Verfahren nach einem der Ansprüche 6 bis 8, dadurch gekennzeichnet, daß der pyroelektrische Film (214) aus Polyvinylidenfluorid ist.

10. Verfahren nach einem der Ansprüche 6 bis 9, dadurch gekennzeichnet, daß man die pyroelektrischen Elemente simultan polarisiert, indem man die Elektroden (106, 108) jedes Sensors benutzt, um das Polarisationssignal zu leiten.

11. Verfahren nach einem der Ansprüche 6 bis 10, dadurch gekennzeichnet, daß die Elektroden (106, 108) gebildet werden durch anisotrope Ätzung der leitenden Schicht (208) unter Verwendung einer Ätzmaske (210) von geeigneter Form.

12. Verfahren nach einem der Ansprüche 6 bis 11, dadurch gekennzeichnet, daß die pyroelektrischen Elemente (104) gebildet werden durch anisotrope Ätzung des pyroelektrischen Films (212) unter Verwendung einer Ätzmaske (214) von geeigneter Form.
